# EUROPEAN PATENT SPECIFICATION

(11) **EP 2 244 314 B1**
(45) Date of publication and mention of the grant of the patent: **30.05.2012**
(21) Application number: 10159983.5
(22) Date of filing: 15.04.2010
(51) Int. Cl.: H01L 41/04, B05B 17/06, B06B 1/02

(54) **Liquid atomiser with piezoelectric vibration device having an improved electronic control circuit, and activation method thereof**
Flüssigkeitszerstäuber mit piezoelektrischer Vibrationsvorrichtung und verbessertem elektronischen Ansteuerungsschaltkreis, sowie Verfahren zur Aktivierung
Atomiseur des liquides avec dispositif à vibration piézoélectrique ayant un circuit de contrôle électronique amélioré, et méthode de l'activer

(30) Priority: 20.04.2009 IT MI20090654
(43) Date of publication of application: 27.10.2010
(73) Proprietor: Zobele Holding SpA, 38100 Trento (IT)
(72) Inventor: Marchetti, Fabio, 38050 Povo (Trento) (IT); Mosconi, Daniel, 38100 Trento (IT)
(74) Representative: Faggioni, Marco

(56) References cited:
- WO-A-00/51747
- DE-A1- 10 122 065
- US-A- 3 885 902
- US-A- 4 319 155
- US-A- 4 641 053
- US-A- 4 689 515
- US-A- 5 099 815
- US-A1- 2002 011 762
- US-A1- 2005 029 905

## Description

### FIELD OF THE INVENTION

The present invention concerns the sector of atomisers of liquid agents wherein atomisation occurs by means of a piezoelectric vibration device, more specifically the invention concerns an atomiser of this type with an improved electronic control circuit of the piezoelectric device.

### STATE OF THE PRIOR ART

Atomisers of liquid agents which employ piezoelectric vibration devices to achieve atomisation and dispersion in the shape of microparticles of the liquid to be nebulised in the environment have been known for some time. Such atomisers generally consist of an alternate-current power generator connected to a piezoelectric element, so as to cause the subsequent fast contraction and expansion thereof. The piezoelectric element - for the atomisation of the liquid to be nebulised to occur - is coupled with a finely perforated, flexible membrane, as free as possible from mechanical constraints, which lies directly in contact with the liquid to be nebulised or in proximal contact with the free end of a porous wick immersed in a tank of said liquid. As can be easily understood, the subsequent expansion and contraction steps of the piezoelectric element cause the vibration of the perforated membrane, and consequently the atomisation of the liquid which has reached by capillarity the membrane through the holes provided in the same, as well as the subsequent dispersion of the liquid in the environment in the form of microparticles.

The piezoelectric element is normally provided with an electronic excitation and control circuit which allows a temporisation of the operation of the piezoelectric element, and in particular a regular alternation of actuation cycles and of rest cycles of the same. As a matter of fact, a temporisation of this type allows to easily control the flow rate of nebulised liquid, to avoid excessive overheating of the piezoelectric material and of the perforated membrane which may impair the duration thereof and to finally reduce the consumption of activation energy, the last one being a feature which is especially useful in battery-operated atomisers, so as to increase the autonomy thereof.

An atomiser for liquids of the above specified type is disclosed for example in EP 0123277 which describes a method to actuate an ultrasonic oscillator for the atomisation of liquids, wherein the oscillator is supplied by an electronic excitation circuit with alternate power voltage, the frequency of which is adjusted to the optimal oscillation power of the oscillator. The electric energy to the oscillator is temporised cyclically between a first value, applied in a first period of time and sufficiently high to exceed the start threshold of the liquid atomisation process also in unfavourable conditions, and a second value - applied in a second period of time and lower than the preceding one - so that the total delivered power, mediated between the two overall considered time intervals, is proportional to the amount of delivered liquid to be atomised per time unit.

Subsequently, EP 1159079 describes a liquid atomiser provided with a battery-powered, temporised, piezoelectric vibration device, wherein, in order to obtain a longer period of service without decline of the atomising performances, the vibrating membrane is caused to vibrate at a high width at the beginning of each activation period, and is then caused to vibrate at a lower width for the remaining part of said activation period.

A further atomiser is known from US 5099815.

### PROBLEM AND SOLUTION

Despite the above-cited last improvement, there is still a strong demand by the market for more efficient battery-operated, portable atomisers having an even longer duration of service. The Applicant has hence studied extensively this problem identifying some innovative technical solutions, based on which the present invention has been devised.

The object of the present invention is hence to provide a more efficient piezoelectric atomiser for the atomisation of liquids through an optimisation of the vibration process of the active element (piezoelectric element and perforated membrane) which further reduces - the performance in the diffusion of finely powdered liquids being equal - the consumption of electric energy, thus extending the useful service period of batteries in portable devices.

Said object is achieved by means, of an atomiser having the features defined in claim 1 and an activation method as defined by claim 11, the dependent claims concerning some further preferred features and embodiments of the invention.

### BRIEF DESCRIPTION OF THE DRAWINGS

Further features and advantages of the invention will be in any case better evident in the following detailed description of a preferred embodiment thereof, given purely by way of a nonlimiting example, and with reference to the accompanying drawings, wherein:
fig. 1 is an exemplifying block diagram of an electronic control circuit for an atomiser with a piezoelectric vibration device according to the invention; and
fig. 2 is a diagram showing the trend over time of the actuation cycles and of the rest cycles of the piezoelectric vibration device;
fig. 3A is a diagram showing the trend over time of the electric excitation voltage of the piezoelectric vibration device during an individual actuation cycle, obtained by means of the electronic control circuit shown in fig. 1, with a fully charged supply battery of 1.5 V; and
fig. 3B is a diagram similar to the one of fig. 3A with a partly empty supply battery, capable of delivering a voltage of 1.0 V.

### DETAILED DESCRIPTION OF THE PREFERRED EMBODIMENT

The electronic control circuit which is described in the following can be used on any prior-art atomiser which provides the use of an electrically excited piezoelectric element to determine the atomisation of the liquid to be nebulised - supplied directly or through a wick - to a vibrating membrane connected to said piezoelectric element. For this reason the intrinsic structure and operation of the atomiser device are not relevant for the present invention and are hence not further described or shown here.

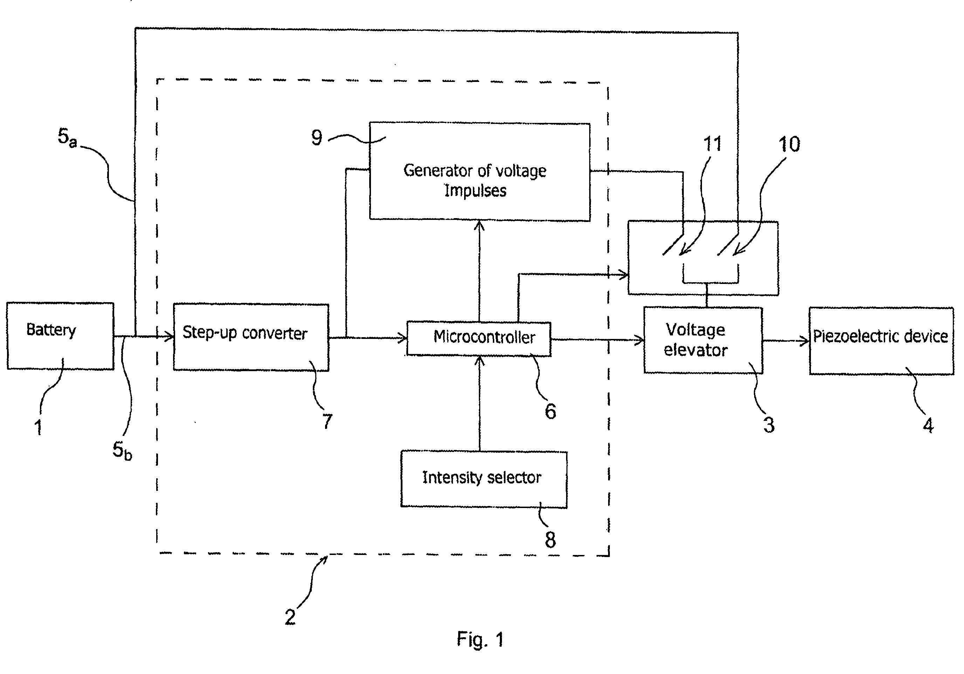

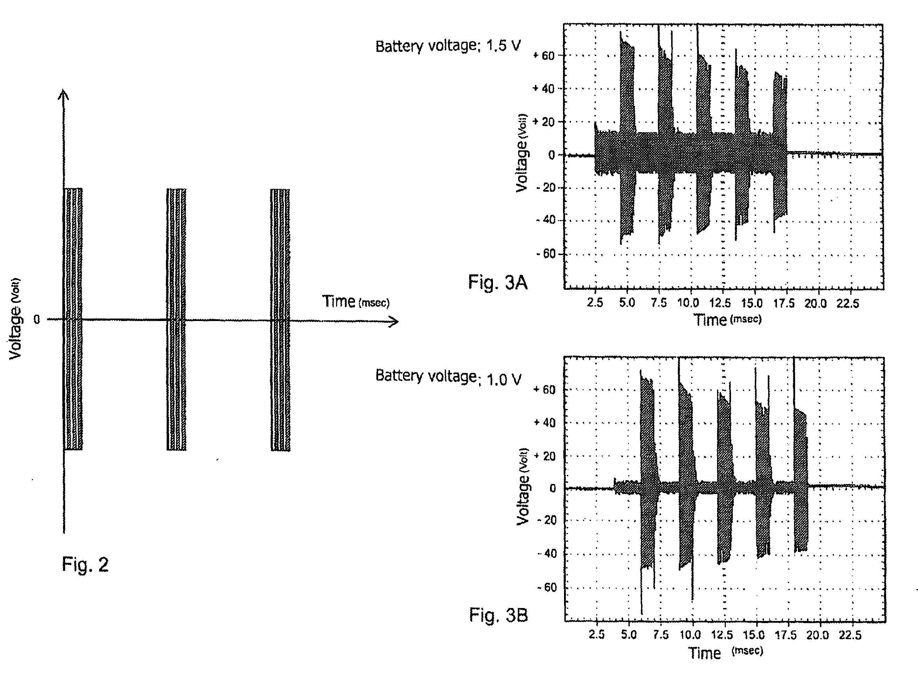

The block diagram shown in fig. 1 shows diagrammatically the constituent components of the electronic excitation circuit of the piezoelectric device of an atomiser according to the invention. Such circuit comprises a battery 1 which delivers direct current, a supply block 2 apt to deliver an excitation voltage according to time-controlled impulses, and finally a voltage elevator 3 which receives said excitation current and supplies a piezoelectric device 4. Impulse voltage supply block 2 comprises inside a DC/DC step-up converter 7, supplied through connection 5b by battery 1 and apt to increase the exit voltage thereof, which voltage is delivered to an impulse generator 9 and to a programmable control device consisting of a microcontroller 6. Microcontroller 6 acts as frequency generator of the circuit and controls the operation of impulse generator 9, and of voltage elevator 3. The generated frequency is obtained by a mathematical algorithm and is a submultiple of the operation frequency of the microcontroller. The temporisation of the exit impulses of generator 9 - that is, the time interval between two subsequent trains of impulses generated by the excitation circuit and applied to the piezoelectric element (rest cycle) - can be adjusted by means of an intensity selector 8, and is diagrammatically shown in fig. 2.

The overall functionality of supply block 2 and the intrinsic features of the different components thereof - as can be understood from the above-reported brief description - are all known per se from the above-described prior-art documents or from the general knowledge of a person skilled in the field, so that it is not believed necessary here to enter in the construction details of the same.

According to the main feature of the present invention, in addition to connection 5b to supply block 2, battery 1 has a second connection 5a in parallel, directly to voltage elevator 3, said two connections can be alternatively actuated by a switching device controlled by microcontroller 6 and comprising switches 10 and 11, arranged on connection 5a and on the output of impulse generator 9 connected to voltage elevator 3, respectively. With this circuit structure it is hence possible to select the excitation voltage of piezoelectric device 4 between one low-voltage excitation and constant width, when switch 10 is closed and switch 11 is opened, and a higher-voltage excitation, with an exponentially decreasing travel, typical of a capacitor discharge, when the switches are in an opposite position and generator 9 is active.

The operation of the electronic control circuit of the above described piezoelectric device is relatively simple, and is based on the discovery made by the Applicant during his tests that it is possible to obtain a high operation efficiency of piezoelectric-device atomiser apparatuses when - within a same activation period - the excitation of the active element is quickly alternated between cycles with relatively high voltage and cycles with relatively low voltage.

Here and in the following, when one refers to an excitation with relatively low voltage it is understood the voltage which can be delivered directly by the batteries normally used for this type of devices and hence a voltage ranging between a maximum voltage value when the batteries are fully charged and a minimum voltage value corresponding to the voltage at which the batteries still manage - in a preset time interval - to supply suitable current for device operation. In the specific case of use of AA-type batteries, this voltage range lies between 1.6 Volt (maximum voltage) and 0.9 Volt (minimum voltage) upstream of voltage elevator 3, which causes that the relatively low voltage which excites piezoelectric device 4, downstream of voltage elevator 3, lies between about 40 Volt peak-to-peak and 10 Volt peak-to-peak. When, here and in the following, one refers to a relatively high-voltage configuration, the peak voltage of impulse generator 9, measured downstream of voltage elevator 3, is intended, which is 2-20 times higher than the above-said relatively low voltage.

A possible explanation of the improved efficiency of the atomiser when operating first with a low-voltage excitation followed by a high-voltage excitation, which, however, must not be interpreted as limiting the scope of protection of the invention, is that during the excitation cycles with a relatively low voltage and hence with low-width vibrations an effect of improved supply and homogenisation of the liquid to be atomised on the vibrating membrane is substantially obtained, so that in the excitation cycles with a relatively high voltage and hence with high-width vibrations one obtains a higher atomising flow rate than the one which can be obtained in the known systems wherein the vibration width is constant or monotonously decreasing from its initial value.

Therefore, as can be understood from the above-described diagram, microcontroller 6 adjusts the intensity of delivery of the nebulised product, acting on the fast alternate closing of the two switches 10 and 11 for the entire duration of each impulse, thus alternating the supply to voltage elevator 3 and hence to piezoelectric device 4 between a constant excitation at a relatively low voltage coming directly from battery 1 and an excitation at an initially higher voltage coming from generator 9 and normally having an exponentially decreasing development. A further adjustment on the intensity of atomisation of the above device, measurable as quantity of nebulised product in a time unit, is obtained by means of the use by the user of switch 8, through which - as already seen above - the duration of the rest cycles of the active element can be adjusted.

In substance, a cyclical electronic circuit for the activation of piezoelectric device 4, based on a clearly defined temporisation of the two above-said steps is so provided, with a typical trend of the activation voltage shown in the diagrams of fig. 3A and 3B for batteries with an output voltage ranging between 1.5 Volt at full charge and 1.0 Volt when the battery is partly empty but still capable of providing to the recharge of the condenser included in impulse generator 9. In a first step switch 10 is closed, so that the voltage at the input of voltage elevator 3, pulsed at the frequency generated by microcontroller 6, is the voltage of battery 1, and therefore the oscillation of the piezoelectric device has a low and constant width, suitable - as said - to favour an even distribution of the liquid across the vaporising membrane avoiding both accumulations at the interface with the wick, and lack of liquid to be nebulised. In a second step, microcontroller 6 opens switch 10 and closes switch 11; the voltage at the input of voltage elevator 3, pulsed at the frequency generated by microcontroller 6, is thus the relatively high voltage of generator 9. These impulses, through voltage elevator 3, activate a more intense vibration of the piezoelectric device and hence of the vibrating membrane, with a resulting full nebulisation of the liquid product accumulated on the same during the previous step. The two steps are - as already said - quickly alternated during a single discharge impulse of generator 9 for very short durations, for example of 1-2 ms each, so that for each cycle of activation of piezoelectric device 4 - generally lasting maximum 30 ms - one can have between 2 and 30 alternate steps of the above-described type. In a preferred application of the present invention, the duration of each individual cycle of activation is of 15 ms, step duration at a relatively low voltage is of 2 ms and step duration at a relatively high voltage is of 1 ms.

The advantages achieved by the atomiser according to the present invention are evident. Firstly, during the low-voltage operation steps a much lower consumption of battery 1 is achieved, and since such steps take up overall more than 50% of each activation cycle, the duration increase of the useful life of the battery is remarkable. Secondly, since the impulse generator works for 50% or less of each activation cycle, the condenser of such generator - the electrical features being equal to the previous, single-impulse ones of the prior art - discharges only partially for each activation cycle, further undergoing a first partial recharge during the activation steps at a relatively low voltage. This has two advantageous consequences: as a matter of fact, on the one hand, the difference of the relatively high voltage values between the first and the last peak step of each activation cycle is very moderate, fully to the advantage of the regularity of operation of the piezoelectric device and of its duration; on the other hand, condenser recharge during the rest cycle occurs more rapidly and with less power consumption.

## Claims

1. Liquid atomiser with battery-powered piezoelectric vibration device (4), of the type scheduled to operate between alternate activation cycles and rest cycles and comprising a first electronic supply circuit (2) with an impulse current generator (9) for the activation at a relatively high voltage of said piezoelectric vibration device (4) during the activation cycles, which comprises a second supply circuit (5a) of the piezoelectric vibration device (4) at a relatively low voltage, and a switch device (10, 11) apt to connect in alternate phases the supply of the piezoelectric vibration device (4) to said first circuit or to said second circuit, said alternate-phase supply through said first or said second circuit being per-formed within a same activation cycle, **characterized in that** said second supply circuit (5a) consists of a direct connection to the battery (1).

2. Atomiser as claimed in claim 1), wherein at the beginning of each activation cycle the supply of said piezoelectric vibration device (4) is provided by said second circuit (5a) at a relatively low voltage.

3. Atomiser as claimed in claim 2), wherein, within a single activation cycle of the piezoelectric vibration device (4), said switch device (10, 11) alternates the supply between said first and second circuit in subsequent phases, each having a duration of 1-2 ms.

4. Atomiser as claimed in any one of the preceding claims, wherein said first electronic circuit (2) comprises a microcontroller (6) and an impulse current generator (9), both powered by the battery (1) through a step-up DC/DC converter (7).

5. Atomiser as claimed in claim 4), wherein said microcontroller (6) controls the impulse current generator (9) and the switch device (10, 11).

6. Atomiser as claimed in claim 5), further comprising a voltage elevator (3) arranged between the common exit of said first and second circuit (2, 5a) and the piezoelectric vibration device (4).

7. Atomiser as claimed in claim 6), further comprising an intensity selector (8) to change the duration of said rest cycles.

8. Atomiser as claimed in any one of the preceding claims, wherein said first supply circuit provides an impulse current with a relatively high initial voltage with respect to the voltage of the second supply circuit and with an exponentially decreasing trend.

9. Atomiser as claimed in any one of the preceding claims, wherein said second supply circuit provides a constant current at a relatively low voltage with respect to the initial voltage of the first supply circuit.

10. Atomiser as claimed in claim 8) or 9), wherein said relatively low voltage is a voltage ranging between 40 Volt peak-to-peak and 10 Volt peak-to-peak and said relatively high voltage is a voltage between 2 and 20 times greater than the relatively low voltage.

11. Activation method of a liquid atomiser with a battery-powered piezoelectric vibration device (4), of the type wherein atomiser operation is scheduled between alternate activation cycles and rest cycles, wherein in each atomiser activation cycle, multiple alternate supply phases of the piezoelectric vibration device (4) are performed at a relatively low voltage and at a relatively high voltage, **characterized in that** during the relatively low voltage phases, the piezoelectric vibration device (4) is directly connected to the battery (1), while during the relatively high voltage phases it is connected to an impulse current generator (9).

12. Activation method of an atomiser as claimed in claim 11), wherein the alternance of said supply phases is determined by a switch device (10, 11) controlled by a microcontroller (6).

13. Activation method of an atomiser as claimed in claim 11), wherein the first supply phase, at the beginning of each activation cycle, is a supply phase at a relatively low voltage.

14. Activation method of an atomiser as claimed in claim 11), wherein each of said alternate phases within a single activation cycle has a duration of 1-2 ms.

15. Activation method of an atomiser as claimed in any one of the preceding claims from 11) to 14), further comprising a voltage elevator (3) immediately upstream of the piezoelectric device (4), wherein, in said relatively low-voltage phase, the voltage on the piezoelectric device(4)ranges between 40 Volt peak-to-peak and 10 Volt peak-to-peak and, in said relatively high-voltage phase, the voltage is between 2 and 20 times greater than said relatively low voltage.

## Patentansprüche

1. Flüssigkeitszerstäuber mit einer batteriebetriebenen piezoelektrischen Vibrationsvorrichtung (4), des Typs, der zum Betrieb abwechselnd zwischen Aktivierungs- und Ruhezyklen ausgelegt ist und eine erste elektronische Versorgungsschaltung (2) mit einem Impulsstromgenerator (9) für die Aktivierung bei einer relativ hohen Spannung der genannten piezoelektrischen Vibrationsvorrichtung (4) während der Aktivierungszyklen umfasst, und der eine zweite Versorgungsschaltung (5a) der piezoelektrischen Vibrationsvorrichtung (4) bei einer relativ niedrigen Spannung umfasst, und eine Schaltvorrichtung (10, 11) zum Verbinden, in abwechselnden Phasen, der Versorgung der piezoelektrischen Vibrationsvorrichtung (4) mit der ersten Schaltung oder mit der zweiten Schaltung, wobei die Versorgung in abwechselnden Phasen durch die erste oder zweite Schaltung innerhalb desselben Aktivierungszyklus ausgeführt wird, **dadurch gekennzeichnet, dass** die zweite Versorgungsschaltung (5a) aus einer unmittelbaren Verbindung mit der Batterie (1) besteht.

2. Zerstäuber nach Anspruch 1, **dadurch gekennzeichnet, dass** zu Beginn eines jeden Aktivierungszyklus die Versorgung der piezoelektrischen Vibrationsvorrichtung (4) durch die zweite Schaltung (5a) bei einer relativ niedrigen Spannung erfolgt.

3. Zerstäuber nach Anspruch 2, **dadurch gekennzeichnet, dass** innerhalb eines einzelnen Aktivierungszyklus der piezoelektrischen Vibrationsvorrichtung (4) die genannte Schaltvorrichtung (10, 11) die Versorgung zwischen der ersten und zweiten Schaltung in aufeinanderfolgenden Phasen abwechselt, wobei jede eine Dauer von ein bis zwei ms aufweist.

4. Zerstäuber nach einen der vorangehenden Ansprüche, **dadurch gekennzeichnet, dass** die erste elektronische Schaltung (2) einen Mikrokontroller (6) und einen Impulsstromgenerator (9) aufweist, die jeweils von der Batterie (1) über einen DC/DC-Aufwärtswandler (7) mit Strom versorgt werden.

5. Zerstäuber nach Anspruch 4, **dadurch gekennzeichnet, dass** der Mikrokontroller (6) den Impulsstromgenerator (9) und die Schaltvorrichtung (10, 11) steuert.

6. Zerstäuber nach Anspruch 5, weiter umfassend eine Spannungserhöhungsschaltung (3), die zwischen dem gemeinsamen Ausgang der ersten und zweiten Schaltung (2, 5a) und der piezoelektrischen Vibrationsvorrichtung (4) angeordnet ist.

7. Zerstäuber nach Anspruch 6, weiter umfassend eine Intensitätswähleinrichtung (8) zum Verändern der Zeitdauer der genannten Ruhezyklen.

8. Zerstäuber nach einem der vorangehenden Ansprüche, **dadurch gekennzeichnet, dass** die erste Versorgungsschaltung einen Impulsstrom mit einer relativ hohen anfänglichen Spannung in Bezug auf die Spannung der zweiten Versorgungssehaltung und mit einem exponentiell abnehmenden Verlauf aufweist.

9. Zerstäuber nach einem der vorangehenden Ansprüche, **dadurch gekennzeichnet, dass** die zweite Versorgungsschaltung einen konstanten Strom bei einer relativ niedrigen Spannung in Bezug auf die anfängliche Spannung der ersten Versorgungsschaltung liefert.

10. Zerstäuber nach Anspruch 8 oder 9, **dadurch gekennzeichnet, dass** die genannte relativ niedrige Spannung eine Spannung ist, die im Bereich zwischen 40 Volt Spitze-Spitze und 10 Volt Spitze-Spitze liegt, und die genannte relativ hohe Spannung eine Spannung ist, die zwischen 2 und 20 Mal größer als die relativ niedrige Spannung ist.

11. Aktivierungsverfahren eines Flüssigkeitszerstäubers mit einer batteriebetriebenen piezoelektrischen Vibrationsvorrichtung (4), des Typs, der für einen Zerstäuberbetrieb zwischen abwechselnden Aktivierungszyklen und Ruhzyklen ausgelegt ist, wobei in jedem Aktivierungszyklus des Zerstäubers mehrere abwechselnde Versorgungsphasen der piezoelektrischen Vibrationsvorrichtung (4) bei einer relativ niedrigen Spannung und bei einer relativ hohen Spannung durchlaufen werden, **dadurch gekennzeichnet, dass** während der Phasen mit relativ niedriger Spannung die piezoelektrische Vibrationsvorrichtung (4) unmittelbar mit der Batterie (1) verbunden ist, wobei sie während der Phasen mit relativ hoher Spannung mit einem Impulsstromgenerator (9) verbunden ist.

12. Aktivierungsverfahren eines Zerstäubers nach Anspruch 11, **dadurch gekennzeichnet, dass** das Abwechseln der genannten Versorgungsphasen durch eine Schalivorrichtung (10, 11), die von einem Mikrokontroller (6) gesteuert wird, bestimmt wird.

13. Aktivierungsverfahren eines Zerstäubers nach Anspruch 11, **dadurch gekennzeichnet, dass** die erste Versorgungsphase, zu Beginn eines jeden Aktivierungszyklus, eine Versorgungsphase bei einer relativ niedrigen Spannung ist.

14. Aktivierungsverfahren eines Zerstäubers nach Anspruch 11, **dadurch gekennzeichnet, dass** jede der abwechselnden Phasen innerhalb eines einzelnen Aktivierungszyklus eine Dauer von 1 bis 2 ms aufweist.

15. Aktivierungsverfahren eines Zerstäubers nach einem der vorangehenden Ansprüche 11 bis 14, weiter umfassend eine Spannungserhöhungsschaltung (3) unmittelbar oberhalb der piezoelektrischen Vorrichtung (4), wobei in der genannten Phase relativ niedriger Spannung die Spannung an der piezoelektrischen Vorrichtung (4) zwischen 40 Volt Spitze-Spitze und 10 Volt Spitze-Spitze liegt, und in der Phase relativ hoher Spannung die Spannung zwischen 2 und 20 Mal größer als die relativ niedrige Spannung ist.

## Revendications

1. Pulvérisateur de liquide avec dispositif de vibration piézoélectrique alimenté par pile ou batterie (4), du type programmé pour fonctionner entre des cycles d'activation et des cycles de repos alternés, et comprenant un premier circuit d'alimentation électronique (2) avec un générateur de courant d'impulsions (9) pour l'activation à une tension relativement élevée dudit dispositif de vibration piézoélectrique (4) durant les cycles d'activation, qui comprend un deuxième circuit d'alimentation (5a) du dispositif de vibration piézoélectrique (4) à une tension relativement basse, et un dispositif de commutateur (10, 11) apte à connecter par phases alternées l'alimentation du dispositif de vibration piézoélectrique (4) audit premier circuit ou audit deuxième circuit, ladite alimentation par phases alternées par l'intermédiaire dudit premier circuit ou dudit deuxième circuit étant effectuée à l'intérieur d'un même cycle d'activation, **caractérisé en ce que** ledit deuxième circuit d'alimentation (5a) est constitué par une connexion directe à la pile ou à la batterie (1).

2. Pulvérisateur selon la revendication 1, dans lequel, au commencement de chaque cycle d'activation, l'alimentation dudit dispositif de vibration piézoélectrique (4) est délivrée par ledit deuxième circuit (5a) à une tension relativement basse.

3. Pulvérisateur selon la revendication 2, dans lequel, à l'intérieur d'un cycle d'activation unique du dispositif de vibration piézoélectrique (4), ledit dispositif de commutateur (10, 11) fait alterner l'alimentation entre lesdits premier et deuxième circuits par phases successives, chacune ayant une durée comprise entre 1 et 2 ms.

4. Pulvérisateur selon l'une quelconque des revendications précédentes, dans lequel ledit premier circuit électronique (2) comprend un micro-dispositif de commande (6) et un générateur de courant d'impulsions (9), tous deux alimentés par la pile ou la batterie (1) par l'intermédiaire d'un convertisseur courant continu/courant continu à élévation de tension (7).

5. Pulvérisateur selon la revendication 4, dans lequel ledit micro-dispositif de commande (6) commande le générateur de courant d'impulsions (9) et le dispositif de commutateur (10, 11).

6. Pulvérisateur selon la revendication 5, comprenant de plus un élévateur de tension (3) disposé entre la sortie commune desdits premier et deuxième circuits (2, 5a) et le dispositif de vibration piézoélectrique (4).

7. Pulvérisateur selon la revendication 6, comprenant de plus un sélecteur d'intensité (8) pour changer la durée desdits cycles de repos.

8. Pulvérisateur selon l'une quelconque des revendications précédentes, dans lequel ledit premier circuit d'alimentation délivre un courant d'impulsions avec une tension initiale relativement élevée par rapport à la tension du deuxième circuit d'alimentation, et avec une tendance à la décroissance exponentielle.

9. Pulvérisateur selon l'une quelconque des revendications précédentes, dans lequel ledit deuxième circuit d'alimentation délivre un courant constant à une tension relativement basse par rapport à la tension initiale du premier circuit d'alimentation.

10. Pulvérisateur selon la revendication 8 ou 9, dans lequel ladite tension relativement basse est une tension comprise entre 40 volts crête-à-crête et 10 volts crête-à-crête, et ladite tension relativement élevée est une tension entre 2 et 20 fois supérieure à la tension relativement basse.

11. Procédé d'activation d'un pulvérisateur de liquide avec un dispositif de vibration piézoélectrique alimenté par pile ou batterie (4), du type dans lequel un fonctionnement de pulvérisateur est programmé entre des cycles d'activation et des cycles de repos alternés, dans lequel, dans chaque cycle d'activation du pulvérisateur, de multiples phases d'alimentation alternées du dispositif de vibration piézoélectrique (4) sont effectuées à une tension relativement basse et à une tension relativement élevée, **caractérisé en ce que**, durant les phases de tension relativement basse, le dispositif de vibration piézoélectrique (4) est directement connecté à la pile ou à la batterie (1), tandis que, durant les phases de tension relativement élevée, il est connecté à un générateur de courant d'impulsions (9).

12. Procédé d'activation d'un pulvérisateur selon la revendication 11, dans lequel l'alternance desdites phases d'alimentation est déterminée par un dispositif de commutateur (10, 11) commandé par un micro-dispositif de commande (6).

13. Procédé d'activation d'un pulvérisateur selon la revendication 11, dans lequel la première phase d'alimentation, au commencement de chaque cycle d'activation, est une phase d'alimentation à une tension relativement basse.

14. Procédé d'activation d'un pulvérisateur selon la revendication 11, dans lequel chacune desdites phases alternées à l'intérieur d'un cycle d'activation unique a une durée comprise entre 1 et 2 ms.

15. Procédé d'activation d'un pulvérisateur selon l'une quelconque des revendications 11 à 14 qui précèdent, comprenant en outre un élévateur de tension (3) immédiatement en amont du dispositif piézoélectrique (4), dans lequel, dans ladite phase de tension relativement basse, la tension sur le dispositif piézoélectrique (4) est située dans une plage comprise entre 40 volts crête-à-crête et 10 volts crête-à-crête, et, dans ladite phase de tension relativement élevée, la tension est entre 2 et 20 fois supérieure à ladite tension relativement basse.
